# FASCICULE DE BREVET EUROPEEN

(11) **EP 3 871 264 B1**
(45) Date de publication et mention de la délivrance du brevet: **07.12.2022**
(21) Numéro de dépôt: 19818244.6
(22) Date de dépôt: 17.10.2019
(51) Int. Cl.: H01L 27/32

(54) **DISPOSITIF D'AFFICHAGE PERMETTANT UN AFFICHAGE JOUR ET NUIT**
ANZEIGEVORRICHTUNG MIT TAG- UND NACHTANZEIGE
DISPLAYING DEVICE ENABLING A DAY-AND-NIGHT DISPLAY

(30) Priorité: 22.10.2018 FR 1801112
(43) Date de publication de la demande: 01.09.2021
(73) Titulaire: Microoled, 38000 Grenoble Cedex 9 (FR)
(72) Inventeur: HAAS, Gunther, 38120 Saint-Egrève (FR); MARCELLIN-DIBON, Eric, 92420 Vaucresson (FR)
(74) Mandataire: Schmidt, Martin Peter
(86) Numéro de dépôt international: PCT/IB2019/001027
(87) Numéro de publication internationale: WO 2020/084338

(56) Documents cités:
- US-A1- 2003 141 808
- US-A1- 2017 148 366

## Description

### Domaine technique de l'invention

L'invention relève du domaine de l'électronique, et plus précisément de celui des dispositifs d'affichage matriciels. Elle concerne notamment un afficheur matriciel de type LED ou OLED. Cet afficheur matriciel est configuré pour permettre l'affichage dans deux modes d'utilisation différents, en fonction de l'intensité de la lumière ambiante ; il permet notamment un affichage en mode jour ou dans un mode nuit.

### Etat de la technique

Les dispositifs d'affichage matriciels sont prévus pour un affichage soit d'images graphiques (tels que des icones, cibles, lettres, chiffres), soit pour un affichage d'images vidéo (par exemple des images enregistrées par une caméra) ; éventuellement ces deux types d'images peuvent être superposées. Ces dispositifs d'affichage sont utilisés par exemple dans des afficheurs de tête haute (en anglais « head-up display ») qui permettent en même temps une vision de l'environnement extérieur, et qui compennent en règle générale un micro-afficheur et un système optique permettant de projeter l'image du micro-afficheur dans l'œil de l'utilisateur ; ce type de système optique est connu sous le nom « see-through ». Les principes optiques de ces dispositifs sont présentés dans l'article « Head-Worn Displays : A Review » par O. Cakmakci et J. Rolland, paru en 2006 dans Journal of Display Technology 2 (3), p. 199-921. Un grand nombre de documents brevets proposent des configurations différentes, par exemple le document US 2013/0127980 (Osterhout Group, Inc.). Les dispositifs d'affichage de tête haute sont utilisés par exemple dans les casques ou lunettes de pilotes, mais également dans des applications de type loisir, notamment pour le sport. Ils sont également utilisés de plus en plus dans les voitures.

Dans de nombreux cas ces systèmes ont deux modes d'utilisation différents, appelés ici « mode jour » et « mode nuit ». Ces deux modes se distinguent en premier lieu par leur luminance : environ 10 000 cd/m² à 20 000 cd/m² en mode jour, et quelques cd/m² en mode nuit. Ils peuvent également se distinguer par la nature des images affichées : en mode jour on affiche principalement des informations graphiques en superposition de la vue naturelle, par exemple des images de cibles, des informations alphanumériques de géolocalisation (GPS), de distance ou de vitesse, alors qu'on mode nuit on affiche par exemple l'image de capteurs de vision de nuit et/ou thermique pour une vision de nuit, éventuellement avec des symboles superposés.

Il est connu que la luminance des afficheurs matriciels de type LED ou OLED diminue en fonction de leur temps d'utilisation. Ce vieillissement dépend de façon exponentielle de la luminance. Le pixel subira donc un viellissement très prononcé en mode jour, et un vieillissement très faible en mode nuit. Ce vieillissement conduira à un autre effet indésirable, commun à tous les écrans émissifs (tubes, écrans plasma, OLED, LED) connu sous les termes de « remanence », « image burn in » ou « sticking image ». A titre d'exemple, si pendant l'opération en mode jour des éléments graphiques sur fond noir sont affichés pendant des centaines d'heures (par exempe une cible), les pixels allumés vont subir un vieillissement important tandis que les pixels qui pour la plupart du temps font partie du fond noir ne vont pratiquement pas vieillir. Si l'on utilise cet afficheur en mode nuit avec des images vidéo, on va apercevoir une image inverse résiduelle superposée à l'image vidéo.

Ce problème est bien connu de l'homme du métier, mais peu de remèdes ont été décrits. Le principal remère est de nature curative : on essaie de compenser la détérioration du pixel. Ainsi, WO 2009/031547 (Canon Kabushiki Kaisha) propose une compensation électronique de la rémanence de l'image pour un écran OLED à matrice active dans lequel chaque pixel comprend un pixel blanc et trois pixels de couleur (R = rouge, V = vert, B = bleu). Dans cette méthode, lorsque le pixel doit afficher une forte intensité de lumière blanche, non seulement le sous-pixel blanc est allumé, mais aussi les trois autres sous-pixels RVB, de manière à obtenir une intensité supplémentaire de lumière blanche qui permet de diminuer l'intensité du sous-pixel blanc. Une autre approche curative est décrite dans WO 2010/048117 (Motorola). Elle implique le comptage du temps d'allumage pour chaque pixel, suivi d'une compensation individuelle après filtrage de l'image qui serait obtenue en l'absence de compensation. Encore une autre approche curative est décrite dans US 2018/0082625 (Samsung) ; elle est basé sur l'ajustement des niveaux de gris. US 2011/0278604 (Canon Kabushiki Kaisha) propose une approche préventive dans laquelle on identifie à chaque instant quels pixels affichent des caractères ou imagtes et quels pixels correspondent à l'arrière-plan de l'affichage, et on ajuste la luminosité de l'affichage des caractères ou images, tout en préservant le contraste de l'image.

Toutes ces méthodes sont complexes et impliquent des calculs numériques importants pour l'analyse et le retraitement des images. Elles sont susceptibles de dégrader l'image.

US 2003/141808 A1 et US 2017/148366 A1 décrivent un affichage comprenant deux zones des pixels, où la somme des surfaces des pixels dans l'une des zones est significativement plus petite que la somme des surfaces des pixels dans l'autre des zones.

Le problème que la présente invention cherche à résoudre est de réduire, et si possible de supprimer, dans un afficheur émissif graphique à haute luminance, l'effet de rémanence sur un affichage de type vidéo, notamment dans un mode d'affichage à faible luminance. Un autre problème que la présente invention cherche à résoudre est de rapprocher les conditions d'opération des pixels entre un mode d'affichage à forte luminance et un mode d'affichage à faible luminance afin de minimiser la diminution de la luminance dans une utilisation mixte, c'est-à-dire dans une alternance entre le mode à forte luminance et le mode d'affichage à faible luminance, et aussi pour bénéficier de la même qualité d'image notamment en termes de contraste et de rendu dans les deux modes.

### Objets de l'invention

Les inventeurs se sont rendus compte que le problème de la rémanence devient particulièrement aigü lorsque l'afficheur est utilisé alternativement à forte luminance et à faible luminance. Plus précisément, la dégradation des pixels se fait en particulier lorsque l'on affiche à haute luminance des images en mode statique, tel que des données graphiques et/ou alphanumériques. Si cet affichage se fait sur fond noir, la rémanence qui en résulte n'est pas visible, ou très eu visible. En revanche, elle devient particulièrement visible lors que l'on affiche à basse luminance sur un fond clair, par exemple lorsque l'on affiche des images d'une caméra de vision nocturne ou thermique.

Selon l'invention ce problème est résolu en subdivisant les zones émettrices élémentaires en deux groupes, à savoir un premier groupe A, utilisé pour l'affichage d'images (ou données) en mode statique ou représentant une image peu dynamique, avec une luminance plutôt elevée, et un deuxième groupe B,utilisé pour l'affichage de données représentant une image dynamique (tel que des données vidéo) avec une luminance plutôt basse .

Typiquement, au sein de chaque pixel au moins une zone émettrice élémentaire du groupe A est réservée à l'affichage d'images statiques. Cependant, cela ne doit pas dégrader la résolution de l'afficheur pour l'affichage d'images en mode dynamique (tel que de données vidéo). Pour un affichage blanc il peut suffir que pour chaque pixel on prévoit que le groupe A comprend une seule zone émettrice élémentaire, alors que le groupe B comprend typiquement une zone éettrice élémentaire pour chacune des trois couleurs élémentaires (rouge, bleu, vert) et possiblement encore une zone émettrice élémentaire additionnelle de couleur blanche.

Selon une caractéristique essentielle de l'invention, pour chaque pixel la somme des surfaces des zones émettrices élémentaires du groupe B est significativement plus petite que la somme des surfaces des zones émettrice élémentaires du groupe A.

Un premier objet de l'invention est un dispositif d'affichage comprenant un afficheur émissif et au moins un contrôleur configuré pour contrôler ledit afficheur émissif, ledit afficheur comprenant une matrice de pixels électroluminescents déposés sur un substrat, chaque pixel étant formé, au moins sur une partie dudit afficheur émissif, d'une pluralité de zones émettrice élémentaires Z,
lesdites zones émettrices élémentaires Z compenant au moins une zone émettrice élémentaire Z_{A} d'un premier groupe A et au moins une zone émettrice élémentaire Z_{B} d'un deuxième groupe B,
ledit dispositif étant caractérisé en ce que le rapport S de la somme S_{B} des surfaces des zones émettrices élémentaires Z_{B} du second groupe B et de la somme S_{A} des surfaces des zones émettrices élémentaires Z_{A} du premier groupe A, défini par S=S_{B}/S_{A}, est inférieur à 0,35 , de préférence inférieur à 0,20 , plus préférentiellement inférieur à 0,10 , et encore plus préférentiellement inférieur à 0,05.

Le dispositif est configuré pour que la luminance maximale L_{A} émise par les zones émettrices élémentaires activés du premier groupe A soit au moins 10 fois, de préférence au moins 100 fois, et encore plus préférentiellement au moins 1000 fois plus grande que la luminance maximale émise par les zones émettrices activées du deuxième groupe B.

Le dispositif peut être configuré de manière à ce que les zones émettrices élémentaires du groupe A génèrent un affichage monochrome, par exemple vert ou rouge ou blanc, et les zones émettrices élémentaires du groupe B génèrent un affichage de la meme couleur.

Dans un autre mode de realisation, le dispositif peut être configuré de manière à ce que les zones émettrices élémentaires du groupe A génèrent un affichage monochrome, par exemple blanc ou vert ou rouge, et les zones émettrices élémentaires du groupe B génèrent un affichage monochrome d'une autre couleur.

Dans encore un autre mode de réalisation, le dispositif peut être configuré de manière à ce que les zones émettrices élémentaires du groupe A génèrent un affichage monochrome, par exemple blanc ou vert ou rouge, et les zones émettrices élémentaires du groupe B génèrent un affichage de couleur, par exemple du type RGB (en utilisant des sous pixels de couleur rouge, vert et bleu) ou du type RGBW (en utilisant des sous pixels de couleur rouge, vert, bleu et blanc).

Dans encore un autre mode de réalisation, le dispositif peut être configuré de manière à ce que les zones émettrices élémentaires du groupe A génèrent un affichage de couleur, et les zones émettrices élémentaires du groupe B génèrent un affichage monochrome. Dans encore un autre mode de réalisation, le dispositif peut être configuré de manière à ce que les zones émettrices élémentaires du groupe A génèrent un affichage de couleur, et les zones émettrices élémentaires du groupe B génèrent un affichage de couleur. Dans tous les modes de réalisation de la présente invention, lesdites couleurs peuvent êtret obtenues à l'aide de filtres se situant entre lesdites zone émettrices élémentaires et l'utilisateur du dispositif.

Dans un mode de réalisation le dispositif comprend un premier bloc de contrôle configuré pour contrôler un flux de données graphiques et ou alphanumériques capable de s'afficher sur ladite matrice de pixels, et un second bloc de contrôle configuré pour contrôler un flux de données vidéo capable de s'afficher sur ladite matrice de pixels. Ledit premier bloc de contrôle est alors avantageusement configuré pour afficher ledit flux de données graphiques ou alphanumériques sur les zones émettrices élémentaires du premier groupe A, et ledit second bloc de contrôle est avantageusement configuré pour afficher ledit flux de données vidéo sur les zones émettrices élémentaires du second groupe B..

Dans ce mode spécifique, les données vidéo sont typiquement des données synchrones, rafraîchies (actualisées) périodiquement, ce rafraîchissement étant typiquement contrôlé par une horloge. En revanche, pour le mode graphique ou alphanumérique l'image peut être statique et reprogrammée (c'est-à-dire actualisée) en tant que de besoin (c'est-à-dire chaque zone émettrice élémentaire peut être rafraîchie par l'envoi d'une nouvelle donnée uniquement lorsque le contenu de sa mémoire statique changera suite à cet enregistrement de la nouvelle donnée dans ladite mémoire statique), ou rafraîchie périodiquement. Dans le premier cas il s'agit de données asynchrones, qui ne dépendent pas d'une horloge ; dans le deuxième cas il peut s'agir de données synchrones.

Les données vidéo peuvent donc présenter un taux de rafraîchissement (appelé aussi fréquence de rafraîchissement) supérieur à celui des données graphiques ou alphanumériques. A titre d'exemple, lorsque l'image graphique ou alphanumérique est rafraîchie périodiquement, le taux de rafraîchissement de cette image peut être faible, notamment inférieur à 0,1 Hz (voire même de 0 Hz) ; il est avantageusement de l'ordre de 0,1 Hz à 1 Hz, mais peut atteindre une fréquence supérieure à 10 Hz. Le taux de rafraîchissement des données vidéo peut typiquement être compris entre 30 Hz et 120 Hz, de préférence entre 60 Hz et 120 Hz.

D'une manière générale le dispositif selon l'invention peut être configuré pour que les zones élémentaires du premier groupe et les zones élémentaires du deuxième groupe n'émettent pas en même temps, et/ou peut être configuré pour que les zones élémentaires du premier groupe émettent lorsque la luminosité ambiante est supérieure à une première valeur seuil, et de préférence uniquement dans ce cas, et/ou peut être configuré pour que les zones élémentaires du deuxième groupe émettent lorsque la luminosité ambiante est inférieure à une deuxième valeur seuil, et de préférence uniquement dans ce cas ; ladite première valeur seuil est par exemple supérieure ou égale à ladite deuxième valeur seuil. Le dispositif peut comprendre un moyen pour détecter si la luminosité ambiante est supérieure ou inférieure à ladite première et/ou à ladite deuxième valeur seuil, et pour activer et/ou désactiver les zones élémentaires du groupe qui doivent émettre ou ne doivent pas émettre.

L'invention est de préférence appliquée aux afficheurs sélectionnés dans le groupe formé par : les afficheurs à plasma, les afficheurs à diodes émettrices de lumière (LED), les afficheurs à diodes organiques émettrices de lumière (OLED).

### Description des figures

Les figures 1 et 2 illustrent l'état de la technique, tandis que les figures 3 à 8 représentent différents modes de réalisation et aspects de l'invention ; elles sont données ici à titre d'illustration et ne limitent pas la portée de l'invention.
La figure 1 représente de manière schématique la vue frontale d'un pixel monochrome d'un afficheur selon l'état de la technique.
La figure 2 montre la courbe de vieillissement d'un afficheur OLED formé de pixels selon la figure 1, utilisé à faible luminance dans un mode appeleé ici « mode nuit » (courbe (a)), et utilisé à forte luminance dans un mode appelé ici « mode jour » (courbe (b)). L'axe horizontal représente le temps d'allumage du pixel en heures, l'axe vertical la luminance relative du pixel.
La figure 3 représente de manière schématique un vue frontale d'un pixel monchrome d'un afficheur selon l'invention, permettant alternativement un affichage en mode jour et en mode nuit.
La figure 4 montre la courbe de vieillissement d'un afficheur OLED forme de pixels selon la figure 3, utilisé à faible luminance en mode nuit (courbe (a)) et à forte luminance en mode jour (courbe (b)). L'axe horizontal représente le temps d'allumage du pixel en heures, l'axe vertical la luminance relative du pixel.
La figure 5 montre un autre mode de réalisation d'un pixel monochrome d'un afficheur selon l'invention.
La figure 6 représente de manière schématique une vue frontale d'un pixel de couleur d'un afficheur selon l'invention ; la structure est de type RGBW/W, permettant l'affichage couleur en mode jour et l'affichage blanc en mode nuit.
Les figures 7(a) et 7(b) représentent chacune de manière schématique une vue frontale d'un autre pixel de couleur d'un afficheur selon l'invention ; la structure est de type RGB/W, permettant, pour le mode de réalisation de la figure 7(a), l'affichage couleur en mode jour et l'affichage blanc en mode nuit, et pour le mode de réalisation de la figure (b), l'affichage couleur en mode nuit et l'affichage blanc en mode jour.
La figure 8 représente de manière schématique une vue frontale d'un autre pixel de couleur d'un afficheur selon l'invention ; la structure est de type W/RGB.
La figure 9 représente de manière schématique la structure des lignes et colonnes d'un afficheur matriciel selon l'invention.
La figure 10 représente de manière schématique les signaux appliqués aux lignes pour une période de trame tₜᵣₐₘₑ.

Les références numériques suivantes sont utilisées dans la présente description et dans les figures :

| | | | | |
|---|---|---|---|---|
| 1 | Pixel monochrome (état de l'art) | 2 | Zone d'isolation électrique | |
| 3 | Zone émettrice élémentaire | 10 | Pixel monochrome (invention) | |
| 11 | 1^{ère} zone émettrice élementaire | 12 | 2^{ème} zone émettrice élémentaire | |
| 13,14 | Zones d'isolation électrique | 20,30 | Pixel de couleur (invention) | |
| 21,31, 41 | Zone émettrice élémentaire rouge | 22,32, 42 | Zone émettrice élémentaire verte | |
| 23,33, 43 | Zone émettrice élémentaire bleue | 24 | Zone émettrice élémentaire blanche | |
| 25,35, 44 | Zone émettrice élémentaire monochrome ou blanche | 40 | Pixel de couleur (invention) | |
| | | 26,27,36 | | Zone d'isolation électrique |
| 100 | Matrice de pixels | 101 | Pixel | |
| 102 | 1^{ère} zone émettrice élémentaire | 103 | 2^{ème} zone émettrice élémentaire | |
| 110 | Bloc de contrôle | 120 | Driver des colonnes | |
| 130 | Driver des lignes | | | |

### Description détaillée

L'invention sera expliquée ici en référence à une matrice de pixels de type OLED, mais peut être mise en œuvre également avec une matrice de pixels électroluminescents utilisant des semiconducteurs inorganiques ou des diodes electroluminescentes (LED). Dans ce qui suit, on appelle le mode d'affichage à forte luminance le mode « jour » et le mode d'affichage à faible luminance le mode « nuit ».

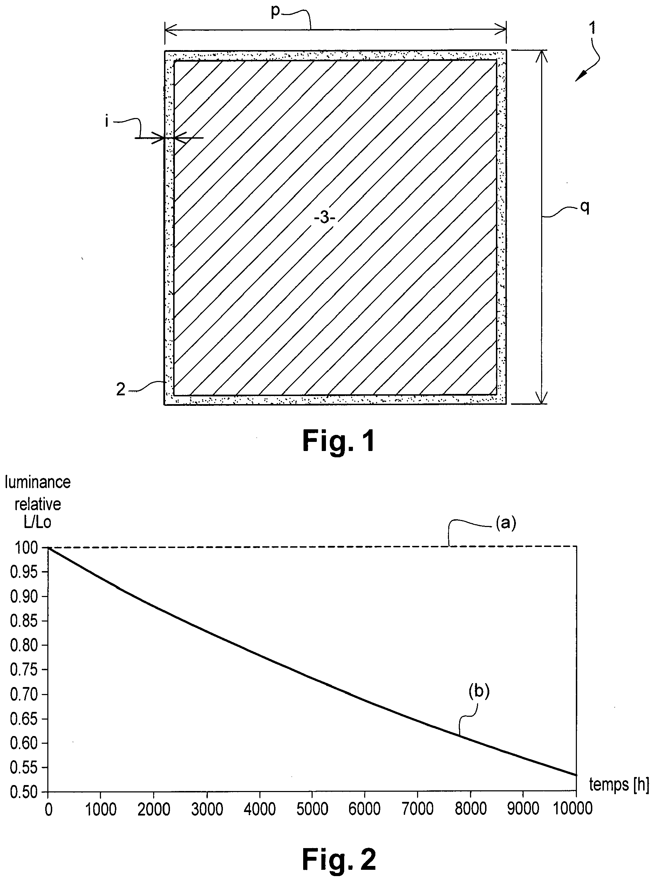

Selon l'état de la technique, pour une matrice de pixels d'un écran électroluminescent monochrome, chaque zone émettrice élémentaire correspond en général à un pixel ; pour un écran couleur chaque pixel se décompose en plusieurs sous-pixels à adressage individuel, et ce sont ces sous-pixels qui correspondent alors aux zones émettrices élémentaires. La figure 1 montre un pixel monochrome de type OLED d'un dispositif d'affichage selon l'état de la technique. Ce pixel 1 présente une zone émettrice élémentaire 3 d'un pas horizontal p et d'un pas vertical q sensiblement identique à p. Il comprend une zone d'isolation électrique 2 qui l'entoure complètement ; cette zone d'isolation électrique 2 présente une largeur *i* sur son pourtour. La surface active totale S du pixel 1, hors zone d'isolation électrique 2, est ainsi égale à (*p*-2*i*)(*q*-2*i*)*.* Les surfaces actives de deux pixels voisins sont donc sépârées d'une zone d'isolation électrique de largeur 2i.

Un tel afficheur est normalement contrôlé de manière à ce que la densité de courant à travers la diode électroluminescente soit très différente en mode jour et en mode nuit. Ce fait explique le fort vieillissement du pixel en mode jour, comme cela ressort de la figure 2. On voit que le pixel utilisé en mode nuit de vieillit tres peu (courbe (a)): la luminance L garde quasiment la valeur initiale L₀ même après 10 000 h d'émission. La courbe correspondante pour le pixel utilisé en mode jour (courbe (b)) montre une forte décroissance.

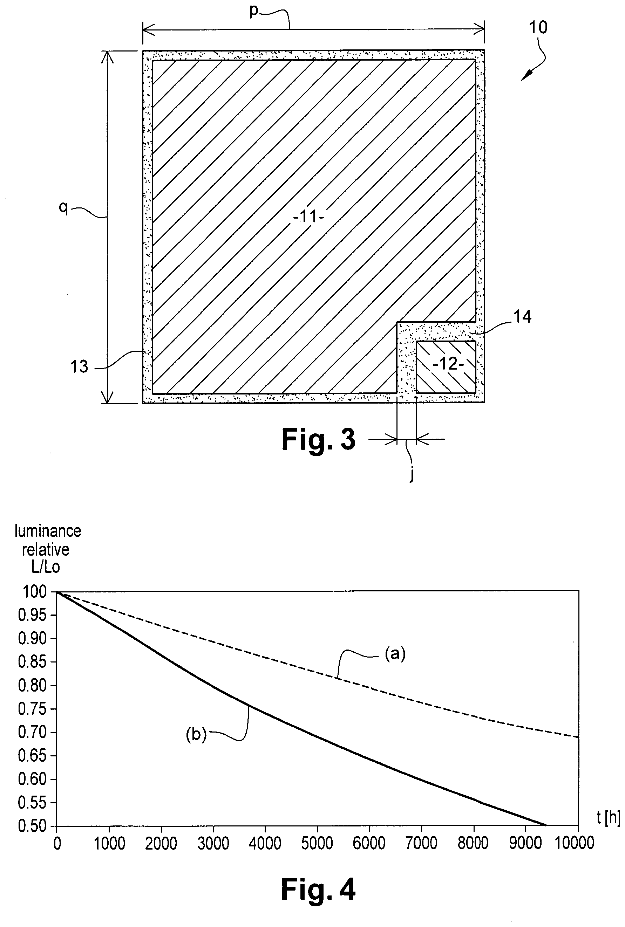

L'invention sera décrite d'abord pour un mode de réalisation d'afficheur monochrome, qui représente le cas le plus simple. La figure 3 présente un pixel **10** d'un afficheur monochrome de type OLED selon l'invention. Ce pixel présente une largeur p et une longueur q sensiblement identique à la largeur. Il comprend une zone d'isolation électrique **13** de largeur *i* qui l'entoure complètement. Selon une caractéristique essentielle de l'invention le pixel **10** comprend une première **11** et une deuxième **12** zone émettrice élémentaire. La surface active totale du pixel **10,** hors zone d'isolation électrique **13,** comprend ainsi la surface S_{A} de ladite première zone émettrice élémentaire **11,** et la surface S_{B} de ladite deuxième zone émettrice élémentaire **12.** La surface S_{A} de la première zone émettrice élémentaire **11** est supérieure à la surface S_{B} de la deuxième zone émettrice élémentaire **12,** et de préférence au moins cinq fois, et encore plus préférentiellement au moins dix fois supérieure. Une zone d'isolation électrique **14** de largeur j sépare les deux surfaces S_{A} et S_{B}.

Selon l'invention l'afficheur est configuré de manière à ce que la première **11** et deuxième **12** zone émettrice élémentaire du pixel **10** soient addressables de manière indépendante l'une de l'autre, et de manière à ce que la première zone émettrice élémentaire **11** de surface S_{A} soit utilisée pour l'affichage en mode jour et la deuxième zone élementaire émettrice **12** de surface S_{B} soit utilisée pour l'affichage en mode nuit. De préférence, la surface S_{A} est utilisée uniquement pour l'affichage en mode jour, et la surface S_{B} est utilisée uniquement en mode nuit. Compte tenu du fait qu'en mode nuit la luminance de l'afficheur qui est nécessaire pour que l'affichage soit bien visible par l'utilisateur peut être beaucoup plus faible qu'en mode jour, le rapport des surfaces S=S_{B}/S_{A} peut être inférieur à 1.

Le fait de diviser le pixel **10** monochrome en deux sous-pixels **11,12** de surface S_{A} et S_{B} adressables de manière complètement indépendante permet d'éviter le problème de rémanence généré par le mode jour et visible principalement en mode nuit. De cette façon, le phénomène de rémanence n'apparait pas. Par rapport au pixel monochrome de l'état de la technique de la figure 1, la surface active S_{A} disponible pour l'affichage en mode jour est légèrement plus petite, ce qui nécessite d'augmenter légèrement la densité de courant. Plus le rapport des surfaces S=S_{B}/S_{A} est petit, moins cette augmentation de la densité de courant dans le sous-pixel **11** de surface S_{A} est significative, et moins elle risque d'accélérer la dégradation et donc la perte de luminance de ce sous-pixel **11.**

En revanche, le vieillissement du sous-pixel **12** de surface S_{B} (utilisé typiquement en mode nuit) de l'afficheur selon l'invention est très faible comparé au vieillissement du sous-pixel **11** de surface S_{A} (utilisé typiquement en mode jour). La surface S_{B} du pixel utilisé en mode affichage nuit peut être très petite par rapport à la surface S_{A} du pixel utilisé en mode affichage jour. De préférence S=S_{B}/S_{A} est inférieur à 0,20 , plus préférentiellement inférieur à 0,10 , et encore plus préférentiellement inférieur à 0,05. Dans un mode de réalisation avantageux on sélectionne le rapport de surfaces S=S_{B}/S_{A} de manière à ce que les densités de courant et donc les courbes de vieillissement en mode jour et nuit s'approchent.

La zone d'isolation électrique **14** qui sépare les zones S_{A} et S_{B} peut avoir une largeur j d'environ 2i. Cette distance peut éventuellement être diminuée comme il n'y a pas forcement besoin d'isolation optique ou électrique entre les surfaces S_{A} et S_{B} comparé à l'isolation entre deux pixels ; cette diminution des zones optiquement inactives de la matrice de pixels permet d'améliorer la qualité de l'afficheur, ainsi que sa durée de vie. En effet, lorsque la largeur de la zone d'isolation électrique augmente on doit augmenter la densité de courant vu par la couche OLED, ce qui diminue sa durée de vie. En pratique, *i* est typiquement de l'ordre de 0,5 µm, selon les technologies CMOS actuellement disponibles. De manière préférée la largeur j de la zone inactive **14** ne dépasse pas 2*i* ; elle peut être comprise entre *i* et 2 *i*.

Si on utlise plusieurs zones émettrices élémentaires différentes (typiquement de couleur différente) pour former le sous-pixel destiné à l'affichage jour, et des exemples seront donnés ci-dessous, ce qui vient d'être dit sur le rapport de surface S vaut pour la somme des zones émettrices élémentaires destinées à l'affichage jour. La remarque analogue s'applique au cas où l'on utilise plusieurs zones émettrices élémentaires différentes (typiquement de couleur différente) pour former le sous-pixel destiné à l'affichage nuit : c'est à la somme des zones émettrices élémentaires destinées à l'affichage nuit que s'applique le rapport de surface S.

La figure 4 montre les courbes de dégradation de l'afficheur OLED selon la figure 3 en mode jour et et mode nuit, avec un rapport de surface S =0,035. On voit que la durée de vie des deux zones émettrices élementaires (courbe (a) : zone émettrice élémentaire **12** de surface S_{B} ; courbe (b) : zone émettrice élémentaire **11** de surface S_{A}) diminue légèrement par rapport à l'état de la technique représenté par la figure 2. Cependant, en pratique cet écart n'est pas très signficatif, et il peut être diminué par des mesures appropriées. En particulier, on peut optimiser la valeur du rapport de surfaces S selon le temps relatif d'utilisation en mode jour et en mode nuit, ce qui permet de minimiser la dégradation de la luminance totale pendant l'utilisation des deux modes. Par ailleurs, comme mentionné ci-dessus, on peut diminuer la fraction de la zone inactive **14,** par exemple en diminuant sa largeur j en dessous de la valeur 2 *i*. Comme les deux zones émettrices élémentaires **12,13** du pixel **1** ne sont pas utilisés simultanément, une diminution de l'isolation électrique ou optique ne va pas dégrader la résolution de l'écran, contrairement à ce qui est le cas pour l'isolation entre deux pixels.

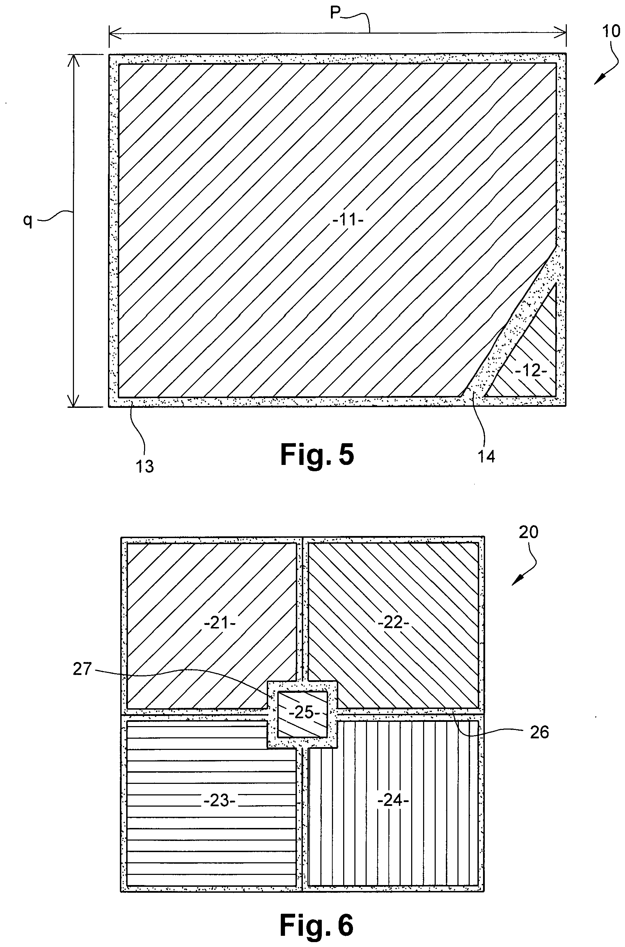

Cet afficheur monochrome selon l'invention peut être réalisé selon plusieurs variantes. Dans une première variante (non montrée sur les figures), le pixel n'a pas une forme carrée mais une forme rectangulaire ou autre. Dans une deuxième variante de l'invention, la deuxième zone émettrice élémentaire du pixel n'a pas une forme carrée mais rectangulaire ou autre. Ces deux variantes peuvent être combinées, comme cela est montré sur la figure 5 où le pixel **10** a une forme rectangulaire et la deuxième zone élémentaire **12** a une forme triangulaire.

Nous décrivons maintenant une matrice de pixels d'un écran d'affichage couleur selon l'invention. De manière connue, toutes les zones émettrices élémentaires peuvent émettre de la lumière blanche et lesdites couleurs peuvent être obtenues à l'aide de filtres se situant entre lesdites zone émettrices élémentaires et l'utilisateur du dispositif. Alternativement, les zones émettrices élémentaires peuvent être conçues pour émettre directement de la lumière de la couleur spectrale voulue.

La figure 6 présente un premier mode de réalisation. Le pixel **20** élémentaire d'un écran couleur comprend plusieurs zones émettrices élémentaires (sous-pixels), dans cet exemple une zone émettrice pour chacune des trois couleurs primaires rouge **21,** vert **22,** bleu **23,** qui peuvent éventuellement être complétées par un quatrième sous pixel blanc **24.** Selon l'invention ces zones sont utilisées en mode jour. Deux de ces zones émettrices élémentaires voisines sont séparées par une zone d'isolation électrique **26** de largeur *i*. Une autre zone émettrice élémentaire **25,** utilisée selon l'invention en mode nuit, se trouve au centre du pixel **20.** Elle est séparée des zones émettrices élémentaires voisines **21,22,23,24** par une zone inactive inactive **27** de largeur j, dont la valeur est typiquement supérieure à *i*, et qui peut être 2*i* ou moins, comme cela a été expliqué en relation avec la figure 3.

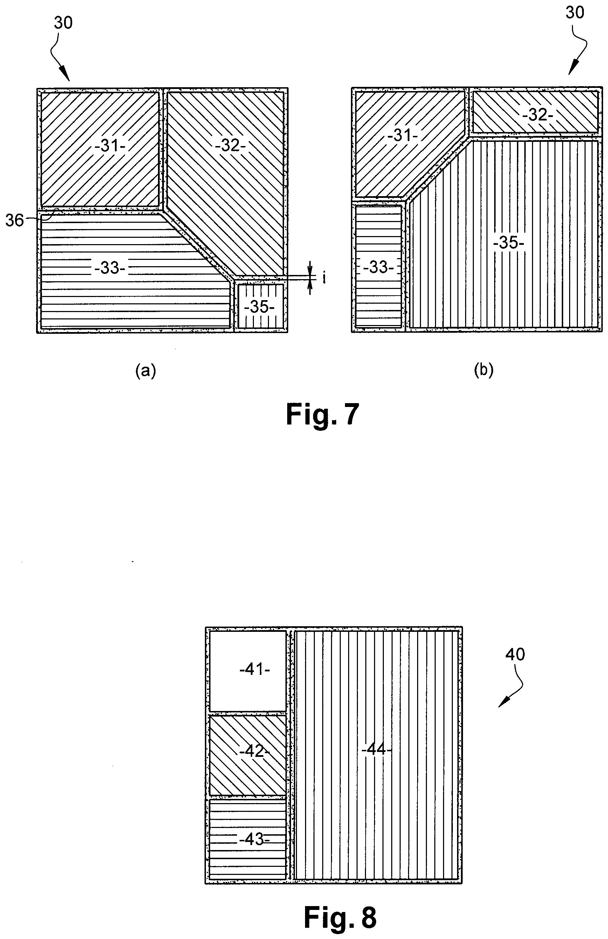

La figure 7 présente deux autres modes de réalisation d'un écran couleur. La figure 7(a) montre un pixel **30** élémentaire d'un écran d'affichage, ledit pixel comprenant une zone émettrice élémentaire pour chacune des trois couleurs primaires rouge **31,** vert **32,** bleu **33** ; ces zones de couleur (abrégées ici RVB) forment les zones du groupe A et peuvent être utilisées par exemple en mode jour. Une autre zone émettrice élémentaire **35,** qui forme le groupe B, émet de la lumière blanche. Toutes les zones émettrices élémentaires sont séparées par une zone d'isolation électrique **36** de largeur *i*. La zone du groupe B peut être utilisée en mode nuit.

La figure 7(b) montre un pixel élémentaire d'un autre écran d'affichage, ledit pixel comprenant une zone émettrice élémentaire pour chacune des trois couleurs primaires rouge **31,** vert **32,** bleu **33** ; ces zones de couleur (abrégées ici RVB) forment les zones du groupe B et peuvent être utilisées par exemple en mode nuit. Une autre zone émettrice élémentaire **35,** qui forme le groupe A, émet de la lumière blanche. La zone du groupe A peut être utilisée en mode jour.

Le mode de réalisation d'un pixel **40** montré sur la figure 8 est optimisé pour un cas d'utilisation particulier, dans lequel on affiche en mode nuit des images vidéo couleur ; ce sont les zones émettrices élémentaires de couleur rouge **41,** vert **42** et bleu **43** qui forment les zones du groupe B et qui génèrent ces images vidéo à faible luminance. En mode jour on affiche une information graphique monochrome (par exemple blanche) à haute luminance par le sous-pixel **44** (qui représente le groupe A) dont la surface est significativement plus grande que celle des sous-pixels utilisés pour le mode nuit. Bien évidemment, les zones émettrices élémentaires RVB **31,32,33** n'ont pas besoin d'avoir la même superficie les unes par rapport aux autres.

Bien évidemment, dans le mode de réalisation des figures 6 et 7(a), les zones émettrices élémentaires **25** et **35** du groupe A peuvent émettre une lumière d'une couleur autre que blanche ou peuvent être constituées eux meme des sous pixels, par exemple R, G, et B ou R, G, B, et W, et/ou les zones émettrices élémentaires du groupe B **21-24** et **31-33** peuvent être au nombre de deux (par exemple rouge et vert) ou au nombre de quatre (rouge, bleu, vert, blanc). De même, dans le mode de réalisation des figure 7(b) et 8 les zones émettrices élémentaires **35** et **44** du groupe A peuvent émettre une lumière d'une couleur autre que blanche ou peuvent etre constituées ellesmêmes des sous pixels, et/ou les zones émettrices élémentaires du groupe B **31-33** et **41-43** peuvent être au nombre de deux (par exemple rouge et vert) ou au nombre de quatre (rouge, bleu, vert, blanc).

Comme indiqué ci-dessus en relation avec la figure 3, d'autres répartitions et affectations des zones émettrices élémentaires au mode jour et au mode nuit sont possibles.

Le dispositif selon l'invention peut comprendre une afficheur matriciel à émission par le haut (en anglais : « top emission »). Il peut être formé sur un substrat opaque (typiquement une tranche de silicium) ou sur un substrat transparent, typiquement une tranche de verre recouverte d'un oxyde conducteur transparent ; la lumière est émise par le haut (i.e. par la face opposée au substrat). Alternativement le dispositif selon l'invention peut comprendre un afficheur matriciel en mode émission par le bas.

Dans un mode de réalisation très préféré de l'invention, toutes les zones émettrices élémentaires émettent de la lumière blanche, et la couleur d'affichage pour chaque zone émettrice élémentaire est générée par un filtre de couleur.

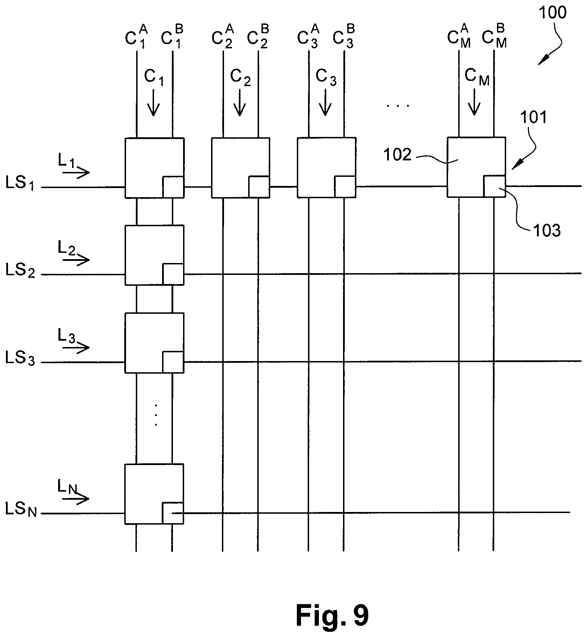

La figure 9 montre de manière schématique la structure des lignes et colonnes d'un dispositif d'affichage selon l'invention. La figure montre plus particulièrement une matrice **100** de pixels **101** électroluminescents déposés sur un substrat, chaque pixel **101** étant formé de deux zones émettrice élémentaires, à savoir une première zone émettrice élémentaire Z_{A} **102** et une deuxième zone émettrice élémentaire Z_{B} **103,** avec une superficie S_{B} << S_{A}. Les pixels **101** sont alignés selon N lignes L (de L₁ à L_{N}) et M colonnes (de C₁ à C_{M}). Les circuits des pixels peuvent être réalisés selon des technologies connues de l'homme du métier sous les sigles Matrice Active (par exemple AMOLED) ou DRAM (Dynamic Random Access Memory, i.e. mémoire vive dynamique) ou alternativement selon le concept SRAM (Static Random Access Memory, i.e. mémoire vive statique).

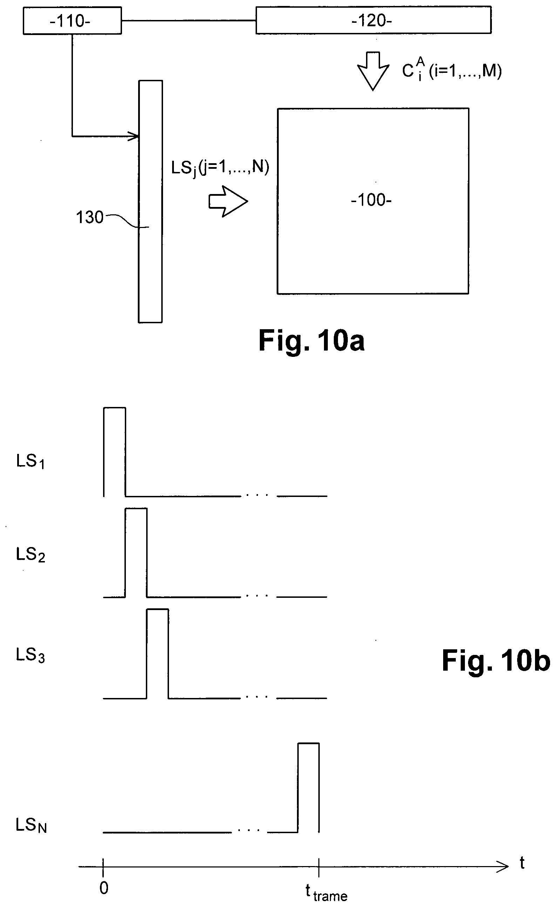

La figure 10(a) montre de manière schématique une structure d'adressage utile pour la réalisation d'un dispositif d'affichage selon l'invention. Les N lignes de L₁ à L_{N} de la matrice **100** de pixels, qui peuvent être électroluminescents, sont controlées par un driver de lignes **130,** alors que les M colonnes C₁ à C_{M} sont contrôlées par un driver de colonnes **120** qui reçoit ses signaux par un bloc de contrôle **110** permettant typiquement la gestion d'un flux vidéo jusqu'à son affchage sur la matrice de pixels **100.**

A titre d'exemple, dans un mode de réalisation ledit flux vidéo, qui est un flux de données numériques, est envoyé vers un driver de colonnes **120** qui comprend successivement un démultiplexeur de registre à décalage horizontal, un comparateur numérique (qui génère un flux de données analogiques) et un circuit d'échantillonnage et de maintien, qui envoie le signal vers les portes verticales de la matrice de pixels **100.**

Le driver de lignes **130** (typiquement un registre à décalage vertical ou un démultiplexeur) donne les ordres sur les lignes horizontales de la matrice de pixels **100.** Dans un mode de réalisation il comprend un séquenceur et un registre à décalage vertical ; ce dernier reçoit du séquenceur les ordres pour afficher l'information sur les lignes de pixels.

La figure 10(b) montre de manière schématique la trame de balayage de la matrice de pixels qui se fait ligne par ligne. Pour chacune des N lignes de L₁ à L_{N} le balayage par les signaux des M colonnes de C₁ à C_{M} comprend deux signaux par pixel : un pour les zones émettrices élémentaires Z_{A} du premier groupe, et un pour les zones émettrices élémentaires Z_{B} du second groupe. Ainsi, sur la ligne LS₁ le balayage des colonnes C₁ à C_{M} permet d'afficher sur les zones émettrices élémentaires correspondantes les données des circuits C^{A}₁ , C^{A}₂, ..., C^{A}_{M} et C^{B}₁ , C^{B}₂, ..., C^{B}_{M} ; sur la ligne LS₂ le balayage des colonnes C₁ à C_{M} permet d'afficher sur les zones émettrices élémentaires correspondantes les données des circuits C^{A}₁ , C^{A}₁, ..., C^{A}_{M} ; et ainsi de suite.

Nous décrivons maintenant l'utilisation des matrices de pixel selon l'invention en modes dits mode jour et mode nuit.

Le dispositif selon l'invention peut comprendre un premier bloc de contrôle configuré pour contrôler un flux de données graphiques et ou alphanumériques capable de s'afficher sur ladite matrice de pixels, et un second bloc de contrôle configuré pour contrôler un flux de données vidéo capable capable de s'afficher sur ladite matrice de pixels. Ledit premier bloc de contrôle peut être configuré pour afficher ledit flux de données graphiques ou alphanumériques sur les zones émettrices élémentaires du premier groupe A, et ledit second bloc de contrôle est configuré pour afficher ledit flux de données vidéo sur les zones émettrices élémentaires du deuxième groupe B.

Alternativement, le dispositif selon l'invention peut comprend un seul bloc de contrôle configuré pour contrôler à la fois le flux de données vidéo et le flux de données graphiques et/ou alpanumériques.

Avantageusement les zones élémentaires du premier groupe émettent en mode « jour » et les zones élémentaires du deuxième groupe émettent en mode « nuit ».

On peut prévoir que les zones élémentaires du premier groupe émettent lorsque la luminosité ambiante est supérieure à une première valeur seuil, et de préférence uniquement dans ce cas. On peut prévoir que les zones élémentaires du deuxième groupe émettent lorsque la luminosité ambiante est inférieure à une deuxième valeur seuil, et de préférence uniquement dans ce cas. Ladite première valeur seuil est supérieure ou égale à ladite deuxième valeur seuil.

Le basculement entre le mode jour et le mode nuit peut être manuel ou automatique ; à titre d'exemple le dispositif peut comprendre des moyens pour détecter si la luminosité ambiante est supérieure ou inférieure à ladite première et/ou à ladite deuxième valeur seuil, et pour activer et/ou désactiver les zones élémentaires du groupe qui doivent émettre ou ne doivent pas émettre. Ces moyens peuvent ainsi ajuster la luminosité de l'afficheur en mode jour et/ou en mode nuit à la luminosité ambiante.

Par référence à la terminologie introduite en relation avec la figure 9, nous décrivons ici plusieurs variantes pour la mise en œuvre de l'invention.

Dans une première variante, une voie graphique ou alphanumérique contrôle l'affichage des données sur les zones émettrices élémentaires du premier groupe (circuits C^{A}₁ , C^{A}₂, ..., C^{A}_{M}) ; l'affichage sur les zones émettrices élementaires du deuxième groupe (circuits C^{B}₁ , C^{B}₂, ..., C^{B}_{M}) étant contrôlé par exemple par une voie vidéo,

Dans une seconde variante, une première voie vidéo contrôle l'affichage des données sur les zones émettrices élémentaires du premier groupe (circuits C^{A}₁ , C^{A}₂, ..., C^{A}_{M}) et une deuxième voie vidéo contrôle l'affichage des données sur les zones élémentraires émettrices du deuxième groupe (circuits C^{B}₁ , C^{B}₂, ..., C^{B}_{M}).

Dans une troisième variante, les données affichées sur les zones émettrices élémentaires du premier groupe (circuits C^{A}₁ , C^{A}₂, ..., C^{A}_{M}) sont des données alphanumériques ou graphiques provenant d'un ordinateur, et les données affichées sur les zones émettrices élémentaires du deuxième groupe (circuits C^{B}₁ , C^{B}₂, ..., C^{B}_{M}) proviennent d'une caméra à vision nocturne.

Dans une quatrième variante, les zones élémentaires du premier groupe se décomposent en sous-groupe par couleur, par exemple le circuit C^{A}₁ se décompose en deux, trois (ou quantre) circuits C^{A1}₁ , C^{A2}₁ , C^{A3}₁ ,C^{A4}₁ permettant d'afficher chacun une couleur différente (typiquement rouge, vert, bleu, blanc), cette couleur pouvant être générée de manière indirecte par un filtre coloré posé sur l'afficheur dont toutes les zones émettrices élémentaires émettent une lumière blanche, ou par un choix adapté de la couche émettrice (couche OLED par exemple) de chacune des zones émettrice élémentaires. Dans une cinquième variante, les zones élémentaires du second groupe se décomposent en sous-groupe par couleur, par exemple le circuit C^{B}₁ se décompose en deux, trois ou quatre circuits C^{B1}₁ , C^{B2}₁ , C^{B3}₁ , C^{B4}₁ permettant d'afficher chacun une couleur différente (typiquement rouge, vert, bleu, blanc), cette couleur pouvant être générée de manière indirecte par un filtre coloré posé sur l'afficheur dont toutes les zones émettrices élémentaires émettent une lumière blanche, ou par un choix adapté de la couche émettrice (couche OLED par exemple) de chacune des zones émettrice élémentaires.

Le dispositif selon l'invention est configuré pour que la luminance maximale L_{A} émise par les zones émettrices élémentaires activés du premier groupe A soit au moins 10 fois, de préférence au moins 100 fois, et encore plus préférentiellement au moins 1000 fois plus grande que la luminance maximale émise par les zones émettrices activées du deuxième groupe B. La luminance peut être contrôlée par différents moyens, et typiquement par la combinaison de différents moyens. En particulier, elle dépend typiquement des facteurs suivants : de la surface de la zone émettrice ; de la caractéristique intrinsèque de zones émettrices de la matrice de pixels électroluminents (par exemple la nature des couches émettrices dans le cas d'un OLED) ; des caractéristiques des filtres éventuellement utilisés ; de la programmation en courant ou en tension de la zone émettrice (qui peut être déterminée par son schéma électrique et/ou dépendre d'une programmation extérieure, par exemple en faisant varier un courant ou une tension de contrôle).

## Revendications

1. Dispositif d'affichage comprenant un afficheur émissif et au moins un contrôleur configuré pour contrôler ledit afficheur émissif,
ledit afficheur comprenant une matrice de pixels (100) électroluminescents déposés sur un substrat, chaque pixel (101) étant formé, au moins sur une partie dudit afficheur émissif, d'une pluralité de zones émettrice élémentaires Z,
lesdites zones émettrices élémentaires Z compenant au moins une zone émettrice élémentaire Z_{A} d'un premier groupe A et au moins une zone émettrice élémentaire Z_{B} d'un deuxième groupe B,
et le rapport S de la somme S_{B} des surfaces des zones émettrices élémentaires Z_{B} du second groupe B et de la somme S_{A} des surfaces des zones émettrices élémentaires Z_{A} du premier groupe A, défini par S=S_{B}/S_{A}, est inférieur à 0,35 , préférentiellement inférieur à 0,20, plus préférentiellement inférieur à 0,10 , et encore plus préférentiellement inférieur à 0,05 , et ledit dispositif étant **caractérisé en ce qu'**il est configuré pour que la luminance maximale L_{A} émise par les zones émettrices élémentaires activés du premier groupe A soit au moins 10 fois, de préférence au moins 100 fois, et encore plus préférentiellement au moins 1000 fois plus grande que la luminance maximale émise par les zones émettrices activées du deuxième groupe B.

2. Dispositif selon la revendication 1, caractérisé en ce ledit afficheur est sélectionné dans le groupe formé par : les afficheurs, les afficheurs à diodes émettrices de lumière (LED), les afficheurs à diodes organiques émettrices de lumière (OLED).

3. Dispositif selon l'une quelconque des revendications 1 à 2, **caractérisé en ce que** les zones émettrices élémentaires du groupe A génèrent un affichage monochrome, et les zones émettrices élémentaires du groupe B génèrent un affichage monchrome de la même ou d'une autre couleur, lesdites couleurs étant éventuellement obtenues à l'aide de filtres se situant entre lesdites zone émettrices élémentaires et l'utilisateur du dispositif.

4. Dispositif selon l'une quelconque des revendications 1 à 2, **caractérisé en ce que** les zones émettrices élémentaires du groupe A génèrent un affichage monochrome, de préférence blanc, et les zones émettrices élémentaires du groupe B génèrent un affichage de couleur, lesdites couleurs étant éventuellement obtenues à l'aide de filtres se situant entre lesdites zone émettrices élémentaires et l'utilisateur du dispositif.

5. Dispositif selon l'une quelconque des revendications 1 à 2, **caractérisé en ce que** les zones émettrices élémentaires du groupe B génèrent un affichage monochrome, de préférence blanc, et les zones émettrices élémentaires du groupe A génèrent un affichage de couleur, lesdites couleurs étant éventuellement obtenues à l'aide de filtres se situant entre lesdites zone émettrices élémentaires et l'utilisateur du dispositif.

6. Dispositif selon l'une quelconque des revendications 1 à 2, **caractérisé en ce que** les zones émettrices élémentaires du groupe B génèrent un affichage de couleur, et les zones émettrices élémentaires du groupe A génèrent un affichage de couleur, lesdites couleurs étant éventuellement obtenues à l'aide de filtres se situant entre lesdites zone émettrices élémentaires et l'utilisateur du dispositif.

7. Dispositif selon l'une quelconque des revendications 1 à 6, **caractérisé en ce qu'**il comprend un premier bloc de contrôle configuré pour contrôler un flux de données graphiques et ou alphanumériques capable de s'afficher sur ladite matrice de pixels, et un second bloc de contrôle configuré pour contrôler un flux de données vidéo capable de s'afficher sur ladite matrice de pixels.

8. Dispositif selon la revendications 7, caractérisé en ce ledit premier bloc de contrôle est configuré pour afficher ledit flux de données graphiques ou alphanumériques sur les zones émettrices élémentaires du premier groupe A, et ledit second bloc de contrôle est configuré pour afficher ledit flux de données vidéo sur les zones émettrices élémentaires du deuxième groupe B.

9. Dispositif selon l'une quelconque des revendications 7 ou 8, **caractérisé en ce que** le taux de rafraîchissemement dudit flux de données vidéo est supérieur au taux de rafraîchissement dudit flux de données graphiques ou alphanumériques,

10. Dispositif selon l'une quelconque des revendications 1 à 9, **caractérisé en ce qu'**il est configuré pour que les zones élémentaires du premier groupe et les zones élémentaires du deuxième groupe n'émettent pas en même temps.

11. Dispositif selon l'une quelconque des revendications 1 à 10, **caractérisé en ce qu'**il est configuré pour que les zones élémentaires du premier groupe émettent lorsque la luminosité ambiante est supérieure à une première valeur seuil, et de préférence uniquement dans ce cas.

12. Dispositif selon l'une quelconque des revendications 1 à 11, **caractérisé en ce qu'**il est configuré pour que les zones élémentaires du deuxième groupe émettent lorsque la luminosité ambiante est inférieure à une deuxième valeur seuil, et de préférence uniquement dans ce cas.

13. Dispositif selon la revendication 12 par rapport à la revendication 11, **caractérisé en ce que** ladite première valeur seuil est supérieure ou égale à ladite deuxième valeur seuil.

14. Dispositif selon l'une quelconque des revendications 11 à 13, **caractérisé en ce qu'**il comprend un moyen pour détecter si la luminosité ambiante est supérieure ou inférieure à ladite première et/ou à ladite deuxième valeur seuil, et pour activer et/ou désactiver les zones élémentaires du groupe qui doivent émettre ou ne doivent pas émettre.

## Patentansprüche

1. Anzeigevorrichtung, einen emittierenden Anzeiger umfassend und mindestens einen Controller, konfiguriert, um den emittierenden Anzeiger zu steuern,
wobei der Anzeiger eine Matrix von elektrolumineszenten Pixeln (100) umfasst, die auf einem Substrat abgelagert sind, wobei jedes Pixel (101), mindestens auf einem Teil des emittierenden Anzeigers, aus einer Vielzahl von emittierenden elementaren Zonen Z gebildet ist,
wobei die emittierenden elementaren Zonen Z mindestens eine emittierende elementare Zone Z_{A} einer ersten Gruppe A und mindestens eine emittierende elementare Zone Z_{B} einer zweiten Gruppe B umfassen,
und das Verhältnis S der Summe S_{B} der Oberflächen der emittierenden elementaren Zonen Z_{B} der zweiten Gruppe B und der Summe S_{A} der Oberflächen der emittierenden elementaren Zonen Z_{A} der ersten Gruppe A, definiert durch S=S_{B}/S_{A}, kleiner ist als 0,35, bevorzugt kleiner als 0,20, bevorzugter kleiner als 0,10 und noch bevorzugter kleiner als 0,05, und die Vorrichtung **dadurch gekennzeichnet ist, dass** sie so konfiguriert ist, dass die maximale Leuchtdichte L_{A}, die von den aktivierten emittierenden elementaren Zonen der ersten Gruppe A emittiert wird, mindestens 10-mal, vorzugsweise mindestens 100-mal und noch bevorzugter mindestens 1000-mal größer ist als die maximale Leuchtdichte, die von den aktivierten emittierenden Zonen der zweiten Gruppe B emittiert wird.

2. Vorrichtung nach Anspruch 1, **dadurch gekennzeichnet, dass** der Anzeiger ausgewählt wird aus der Gruppe, gebildet aus: Den Anzeigern, den Anzeigern mit Leuchtdioden (LED) und den Anzeigern mit organischen Leuchtdioden (OLED).

3. Vorrichtung nach einem der Ansprüche 1 bis 2, **dadurch gekennzeichnet, dass** die emittierenden elementaren Zonen der Gruppe A eine monochrome Anzeige erzeugen und die emittierenden elementaren Zonen der Gruppe B eine monochrome Anzeige der gleichen oder einer anderen Farbe erzeugen, wobei die Farben gegebenenfalls mit Hilfe der Filter erhalten werden, die sich zwischen den emittierenden elementaren Zonen und dem Benutzer der Vorrichtung befinden.

4. Vorrichtung nach einem der Ansprüche 1 bis 2, **dadurch gekennzeichnet, dass** die emittierenden elementaren Zonen der Gruppe A eine monochrome, vorzugsweise weiße Anzeige erzeugen und die emittierenden elementaren Zonen der Gruppe B eine farbige Anzeige erzeugen, wobei die Farben gegebenenfalls mit Hilfe der Filter erhalten werden, die sich zwischen den emittierenden elementaren Zonen und dem Benutzer der Vorrichtung befinden.

5. Vorrichtung nach einem der Ansprüche 1 bis 2, **dadurch gekennzeichnet, dass** die emittierenden elementaren Zonen der Gruppe B eine monochrome, vorzugsweise weiße Anzeige erzeugen und die emittierenden elementaren Zonen der Gruppe A eine farbige Anzeige erzeugen, wobei die Farben gegebenenfalls mit Hilfe der Filter erhalten werden, die sich zwischen den emittierenden elementaren Zonen und dem Benutzer der Vorrichtung befinden.

6. Vorrichtung nach einem der Ansprüche 1 bis 2, **dadurch gekennzeichnet, dass** die emittierenden elementaren Zonen der Gruppe B eine farbige Anzeige erzeugen und die emittierenden elementaren Zonen der Gruppe A eine farbige Anzeige erzeugen, wobei die Farben gegebenenfalls mit Hilfe der Filter erhalten werden, die sich zwischen den emittierenden elementaren Zonen und dem Benutzer der Vorrichtung befinden.

7. Vorrichtung nach einem der Ansprüche 1 bis 6, **dadurch gekennzeichnet, dass** sie einen ersten Steuerblock umfasst, konfiguriert, um einen grafischen und/oder alphanumerischen Datenstrom zu steuern, der auf der Pixelmatrix angezeigt werden kann, und einen zweiten Steuerblock, konfiguriert, um einen Videodatenstrom zu steuern, der auf der Pixelmatrix angezeigt werden kann.

8. Vorrichtung nach Anspruch 7, **dadurch gekennzeichnet, dass** der erste Steuerblock konfiguriert ist, um den grafischen oder alphanumerischen Datenstrom auf den emittierenden elementaren Zonen der ersten Gruppe A anzuzeigen, und wobei der zweite Steuerblock konfiguriert ist, um den Videodatenstrom auf den emittierenden elementaren Zonen der zweiten Gruppe B anzuzeigen.

9. Vorrichtung nach einem der Ansprüche 7 oder 8, **dadurch gekennzeichnet, dass** die Bildwiederholrate des Videodatenstroms höher ist als die Bildwiederholrate des grafischen oder alphanumerischen Datenstroms.

10. Vorrichtung nach einem der Ansprüche 1 bis 9, **dadurch gekennzeichnet, dass** sie so konfiguriert ist, dass die elementaren Zonen der ersten Gruppe und die elementaren Zonen der zweiten Gruppe nicht gleichzeitig emittieren.

11. Vorrichtung nach einem der Ansprüche 1 bis 10, **dadurch gekennzeichnet, dass** sie so konfiguriert ist, dass die elementaren Zonen der ersten Gruppe emittieren, wenn die Umgebungshelligkeit über einem ersten Schwellenwert liegt, vorzugsweise nur in diesem Fall.

12. Vorrichtung nach einem der Ansprüche 1 bis 11, **dadurch gekennzeichnet, dass** sie so konfiguriert ist, dass die elementaren Zonen der zweiten Gruppe emittieren, wenn die Umgebungshelligkeit unter einem zweiten Schwellenwert liegt, vorzugsweise nur in diesem Fall.

13. Vorrichtung nach Anspruch 12 bezogen auf Anspruch 11, **dadurch gekennzeichnet, dass** der erste Schwellenwert höher oder gleich dem zweiten Schwellenwert ist.

14. Vorrichtung nach einem der Ansprüche 11 bis 13, **dadurch gekennzeichnet, dass** sie ein Mittel umfasst, zum Erkennen, ob die Umgebungshelligkeit höher oder niedriger ist als der erste und/oder der zweite Schwellenwert, und zum Aktivieren und/oder Deaktivieren der elementaren Zonen der Gruppe, die emittieren sollen oder nicht.

## Claims

1. Displaying device comprising an emissive display and at least one controller configured to control said emissive display,
said display comprising a matrix array (100) of light-emitting pixels deposited on a substrate, each pixel (101) being formed, at least on one portion of said emissive display, of a plurality of elementary emitting zones Z, said elementary emitting zones Z comprising at least one elementary emitting zone Z_{A} of a first group A and at least one elementary emitting zone Z_{B} of a second group B,
and the ratio S of the sum S_{B} of the areas of the elementary emitting zones Z_{B} of the second group B and of the sum S_{A} of the areas of the elementary emitting zones Z_{A} of the first group A, which is defined by S=S_{B}/S_{A}, is less than 0.35, preferably less than 0.20, more preferably less than 0.10, and even more preferably less than 0.05,
and said device being **characterized in that** it is configured so that the maximum brightness L_{A} emitted by the activated elementary emitting zones of the first group A is at least 10 times, preferably at least 100 times, and even more preferably at least 1000 times greater than the maximum brightness emitted by the activated emitting zones of the second group B.

2. Device according to claim 1, **characterized in that** said display is selected from the group formed by: displays, light-emitting diode (LED) displays, organic light-emitting diode (OLED) displays.

3. Device according to any one of claims 1 to 2, **characterized in that** the elementary emitting zones of the group A generate a monochrome display, and the elementary emitting zones of the group B generate a monochrome display of the same or of another color, said colors being optionally obtained using filters located between said elementary emitting zones and the user of the device.

4. Device according to any one of claims 1 to 2, **characterized in that** the elementary emitting zones of the group A generate a monochrome display, preferably white, and the elementary emitting zones of the group B generate a color display, said colors being optionally obtained using filters located between said elementary emitting zones and the user of the device.

5. Device according to any one of claims 1 to 2, **characterized in that** the elementary emitting zones of the group B generate a monochrome display, preferably white, and the elementary emitting zones of the group A generate a color display, said colors being optionally obtained using filters located between said elementary emitting zones and the user of the device.

6. Device according to any one of claims 1 to 2, **characterized in that** the elementary emitting zones of the group B generate a color display, preferably white, and the elementary emitting zones of the group A generate a color display, said colors being optionally obtained using filters located between said elementary emitting zones and the user of the device.

7. Device according to any one of claims 1 to 6, **characterized in that** it comprises a first control block configured to control a graphic and/or alphanumeric data stream capable of being displayed on said pixel matrix array, and a second control block configured to control a video data stream capable of being displayed on said pixel matrix array.

8. Device according to claims 7, **characterized in that** the first control block is configured to display said graphic or alphanumeric data stream on the elementary emitting zones of the first group A, and said second control block is configured to display said video data stream on the elementary emitting zones of the second group B.

9. Device according to any one of claims 7 or 8, **characterized in that** the refresh rate of said video data stream is greater than the refresh rate of said graphic or alphanumeric data stream.

10. Device according to any one of claims 1 to 9, **characterized in that** it is configured so that the elementary zones of the first group and the elementary zones of the second group do not emit at the same time.

11. Device according to any one of claims 1 to 10, **characterized in that** it is configured so that the elementary zones of the first group emit when the ambient brightness is greater than a first threshold value, and preferably only in this case.

12. Device according to any one of claims 1 to 11, **characterized in that** it is configured so that the elementary zones of the second group emit when the ambient brightness is less than a second threshold value, and preferably only in this case.

13. Device according to claim 12 in relation to claim 11, **characterized in that** said first threshold value is greater than or equal to said second threshold value.

14. Device according to any one of claims 11 to 13, **characterized in that** it comprises a means for detecting whether the ambient brightness is greater or less than said first and/or said second threshold value, and for activating and/or deactivating the elementary zones of the group which are to emit or not to emit.
